# EUROPÄISCHE PATENTSCHRIFT

(11) **EP 1 159 625 B1**
(45) Veröffentlichungstag und Bekanntmachung des Hinweises auf die Patenterteilung: **14.09.2005**
(21) Anmeldenummer: 00915119.2
(22) Anmeldetag: 25.02.2000
(51) Int. Cl.: G01R 31/02, G01R 15/20, G01R 15/04

(54) **ANORDNUNG ZUR ERFASSUNG VON IMPEDANZSTÖRSTELLEN BEI SYMMETRISCHEN DATENÜBERTRAGUNGSLEITUNGEN**
DEVICE FOR DETECTING IMPEDANCE DISTURBANCE POINTS IN SYMMETRICAL DATA TRANSMISSION LINES
DISPOSITIF POUR LA DETECTION DE POINTS DE PERTURBATION PAR IMPEDANCE DANS DES LIGNES DE TRANSMISSION DE DONNEES SYMETRIQUES

(30) Priorität: 08.03.1999 DE 19910016
(43) Veröffentlichungstag der Anmeldung: 05.12.2001
(73) Patentinhaber: SIEMENS AKTIENGESELLSCHAFT, 80333 München (DE)
(72) Erfinder: SCHIRL, Werner, D-90411 Nürnberg (DE)
(86) Internationale Anmeldenummer: PCT/DE2000/000540
(87) Internationale Veröffentlichungsnummer: WO 2000/054065

(56) Entgegenhaltungen:
- EP-A- 0 307 729
- EP-A- 0 875 995
- US-A- 5 399 965

## Beschreibung

Die Erfindung betrifft eine Anordnung zur Erfassung von Impedanzstörstellen bei symmetrischen Datenübertragungsleitungen.

Aus der DE 42 05 241 A ist bereits eine Datenübertragungseinrichtung bekannt, mittels der eine bidirektionale, potentialfreie Datenübertragung zwischen einer Masterstufe und einer Unterstufe erfolgen kann. Dies geschieht unter Verwendung einer zweiadrigen Busleitung, einer Koppelschleife und einer Hallspannungsmesseinrichtung, wobei mindestens zwei magnetosensitive Elemente vorhanden sind, von denen das eine in räumlicher Nähe der einen der beiden Adern und das andere in räumlicher Nähe der anderen Ader positioniert ist. Die Hallspannungsmesseinrichtung ist zusammen mit einer Signalverarbeitungsschaltung in Form einer integrierten Schaltung realisiert. Eine Rücksendung von Daten von der Unterstufe zur Masterstufe erfolgt unter Verwendung einer Unterbrecherstufe, die den Strom in der Busleitung definiert unterbricht. Eine Auswertung des Tastverhältnisses in einer Vergleichsschaltung der Masterstufe ermöglicht eine Erkennung eines zurückgemeldeten logischen Zustandes.

Aus der EP 0 875 995 A der Anmelderin ist ebenfalls eine integrierte Datenübertragungsschaltung mit Potentialtrennung zwischen Ein- und Ausgangsschaltkreis bekannt. Der Eingangsschaltkreis weist einen Eingang für binäre Eingangssignale auf. Der Ausgangsschaltkreis enthält ein integriertes, magnetosensitives Koppelelement und mindestens einen vom Koppelelement angesteuerten Ausgang, über den binäre Ausgangssignale abgebbar sind. Um die genannte Datenübertragung zu ermöglichen, sind Leitungsmittel vorgesehen, um in einer die Spannungspotentiale im Ein- und Ausgangsschaltkreis trennenden Weise Eingangssignale in die räumliche Nähe des Koppelelementes zu leiten. Als Koppelelement kann ein integrierter Hallgenerator verwendet werden.

Aus der EP 0 307 729 A ist eine Anordnung zur Erfassung von Impedanzstörstellen bei symmetrischen Datenübertragungsleitungen bekannt. Bei dieser Anordnung ist eine zwei magnetosensitive Elemente aufweisende Auswerteeinheit vorgesehen, wobei beide magnetosensitiven Elemente in räumlicher Nähe des dort vorgesehenen einzigen Leiters angeordnet sind.

Bei symmetrischen, geschirmten und ungeschirmten Datenübertragungsleitungen können im laufenden Betrieb Störungen auftreten, die auf Kurzschlüsse oder Leitungsunterbrechungen zurückzuführen sind. Die Erfassung und Lokalisierung derartiger Störungen erfolgt bisher unter Einsatz von Servicepersonal im Offline-Betrieb. Dabei werden aufwendige Meßgeräte verwendet und vom Fachwissen des Personals Gebrauch gemacht.

Ausgehend von diesem Stand der Technik liegt der Erfindung die Aufgabe zugrunde, einen neuen Weg aufzuzeigen, wie die Erfassung von Impedanzstörstellen bei symmeterischen Datenübertragungsleitungen verbessert werden kann.

Diese Aufgabe wird durch eine Anordnung mit den im Anspruch 1 angegebenen Merkmalen gelöst. Vorteilhafte Ausgestaltungen und Weiterbildungen der Erfindung ergeben sich aus den abhängigen Ansprüchen.

Die Vorteile der Erfindung bestehen insbesondere darin, daß die beanspruchte Erfassung von Impedanzstörstellen potentialgetrennt erfolgt. Die zur Realisierung der Auswerteeinheit notwendigen Baugruppen können in Form einer integrierten Schaltung ausgeführt sein. Dies ermöglicht in einfacher Weise eine rückwirkungsfreie, permanente Überwachung der Leitungen im laufenden Betrieb, so daß auftretende Störungen automatisch durch die Ausgabe eines zugehörigen Fehlersignals signalisiert werden. Die Erfindung ist beispielsweise in allen Bussystemen mit differentieller Signalübertragung verwendbar, beispielsweise dem sogenannten Profibus.

Weitere vorteilhafte Eigenschaften der Erfindung ergeben sich aus der Erläuterung von Ausführungsbeispielen anhand Figuren.

Es zeigt:
- FIG 1: ein Diagramm zur Erläuterung des Grundprinzips der Erfindung,
- FIG 2: ein erstes Ausführungsbeispiel für die Erfindung und
- Figur 3: ein zweites Ausführungsbeispiel für die Erfindung.

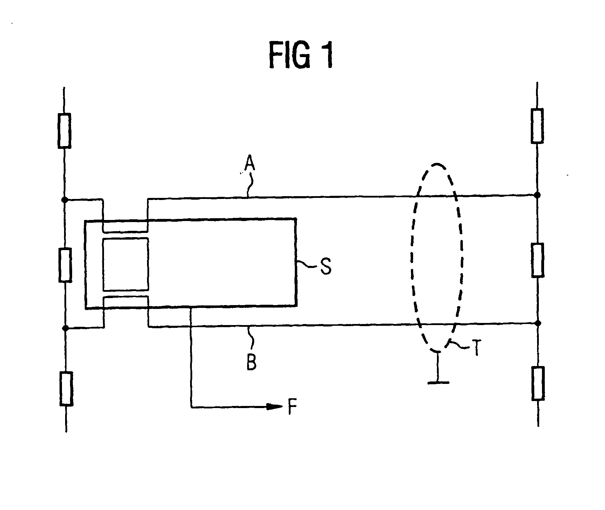

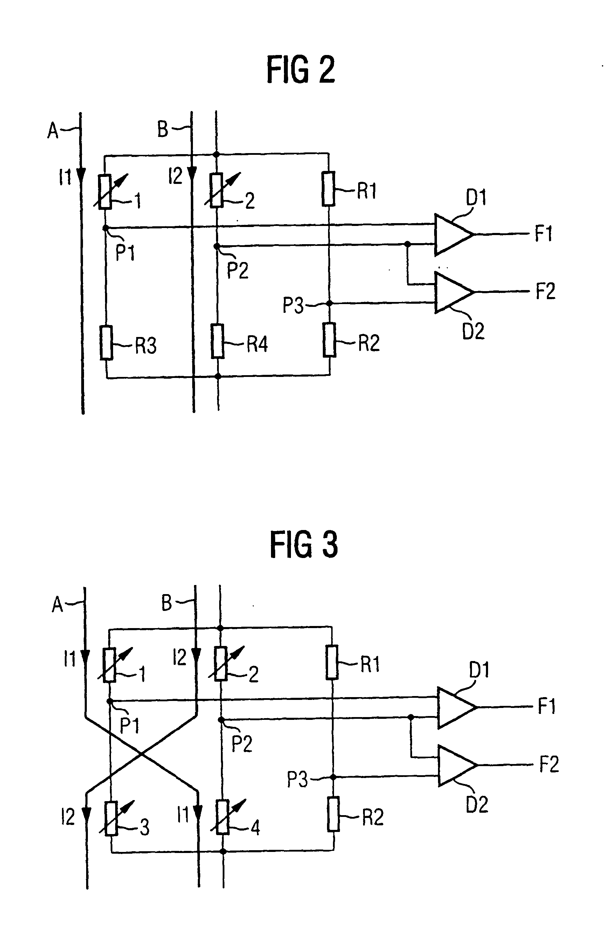

Die Figur 1 zeigt ein Diagramm zur Erläuterung des Grundprinzips der Erfindung. Die beiden Adern A und B eines Bussystems verlaufen parallel zueinander und sind von einer Abschirmung T umgeben. Zwischen den Adern A und B ist eine Auswerteeinheit S vorgesehen, die mindestens zwei magnetosensitive Elemente und eine Auswerteschaltung aufweist, wie unten im Zusammenhang mit den Figuren 2 und 3 näher erläutert wird. Jede der beiden Adern ist mit einem Abschnitt versehen, der in die unmittelbare Nähe eines der magnetosensitiven Elemente der Auswerteeinheit S geführt ist. Mittels der magnetosensitiven Elemente werden die in den Adern fließenden Ströme erfaßt und der Auswerteschaltung der Auswerteeinheit S zugeführt. In dieser erfolgt dann die Ermittlung eines oder mehrerer Fehlersignale F, die an einem Ausgangsanschluß der Schaltung zur Verfügung gestellt werden.

Anhand dieser Fehlersignale ist beispielsweise erkennbar, ob eine der Adern A oder B einen Kurzschluß gegenüber der Abschirmung oder gegenüber Masse aufweist oder ob innerhalb einer der Adern ein Kurzschluß oder eine Unterbrechung vorliegt.

Eine derartige potentialgetrennte Erfassung von Impedanzstörstellen kann nicht nur bei geschirmten, sondern auch bei ungeschirmten Datenübertragungsleitungen erfolgen. Aufgrund der potentialgetrennten Erfassung ist sichergestellt, daß die genannten Leitungen rückwirkungsfrei überwacht werden können. Dies bedeutet, daß der im Betrieb permanent und automatisch erfolgende Meß- bzw. Fehlerdiagnosevorgang ohne negative Auswirkungen auf die übertragenen Signale selbst durchgeführt wird. Dies wiederum hat den Vorteil, daß auch der Sender und der Empfänger der übertragenen Datensignale nicht in unerwünschter Weise gestört werden.

Die Figur 2 zeigt ein erstes, detaillierteres Ausführungsbeispiel für die Erfindung. Die dargestellte Anordnung zur Erfassung von Impedanzstörstellen bei symmetrischen Datenübertragungsleitungen weist zwei parallel zueinander verlaufende Adern A und B auf, über welche Datensignale in Form von Strömen I1 und I2 transportiert werden. In räumlicher Nähe der Ader A ist ein erstes magnetosensitives Element 1 vorgesehen. Ein zweites magnetosensitives Element 2 befindet sich in räumlicher Nähe zur Ader B.

Die magnetosensitiven Elemente 1 und 2 sind Bestandteil einer Auswerteeinheit, welche eine Parallelschaltung mit drei Signalzweigen aufweist und welche weiterhin mit zwei Differenzverstärkern D1 und D2 versehen ist. Der erste Signalzweig enthält eine Reihenschaltung eines ersten Widerstandes R1 und eines zweiten Widerstandes R2. Im zweiten Signalzweig ist eine Reihenschaltung des zweiten magnetosensitiven Elementes 2 und eines vierten Widerstandes R4 vorgesehen. Der dritte Signalzweig enthält eine Reihenschaltung des ersten magnetosensitiven Elementes 1 und eines dritten Widerstandes R3.

Der Verbindungspunkt P1 zwischen dem ersten magnetosensitiven Element 1 und dem dritten Widerstand R3 ist mit einem Eingang des Differenzverstärkers D1 verbunden. Der zweite Eingang des Differenzverstärkers D1 ist an den Verbindungspunkt P2 angeschlossen, der sich zwischen dem zweiten magnetosensitiven Element 2 und dem vierten Widerstand R4 befindet.

Der Verbindungspunkt P2 ist weiterhin an den ersten Eingang des Differenzverstärkers D2 angeschlossen. Dem zweiten Eingang des Differenzverstärkers D2 werden Signale zugeführt, die vom Verbindungspunkt P3 abgeleitet sind, der zwischen den Widerständen R1 und R2 im ersten Signalzweig liegt.

Am Ausgang des Differenzverstärkers D1 steht ein Fehlersignal F1 zur Verfügung, welches Aufschluß darüber gibt, ob eine der beiden Adern A oder B einen Kurzschluß gegenüber der Leitungsabschirmung oder gegenüber Masse aufweist.

Das am Ausgang des Differenzverstärkers D2 bereitgestellte Signal enthält Informationen darüber, ob eine der Adern A oder B selbst einen Kurzschluß oder eine Unterbrechung hat.

Die Figur 3 zeigt ein zweites, detaillierteres Ausführungsbeispiel für die Erfindung. Die dargestellte Anordnung zur Erfassung von Impedanzstörstellen bei symmetrischen Datenübertragungsleitungen weist zwei verdrillte Adern A und B auf, über welche Datensignale in Form von Strömen I1 und I2 transportiert werden. In räumlicher Nähe der Ader A ist ein erstes magnetosensitives Element 1 vorgesehen. Ein zweites magnetosensitives Element 2 befindet sich in räumlicher Nähe zur Ader B.

Die magnetosensitiven Elemente 1 und 2 sind Bestandteil einer Auswerteeinheit, welche eine Parallelschaltung mit drei Signalzweigen aufweist und welche weiterhin mit zwei Differenzverstärkern D1 und D2 versehen ist. Der erste Signalzweig enthält eine Reihenschaltung eines ersten Widerstandes R1 und eines zweiten Widerstandes R2. Im zweiten Signalzweig ist eine Reihenschaltung des zweiten magnetosensitiven Elementes 2 und eines vierten magnetosensitiven Elementes 4 vorgesehen. Der dritte Signalzweig enthält eine Reihenschaltung des ersten magnetosensitiven Elementes 1 und eines dritten magnetosensitiven Elementes 3.

Aufgrund der Verdrillung der Adern A und B sind die magnetosensitiven Elemente 1 und 4 in der Nähe der Ader A und die magnetosensitiven Elemente 2 und 3 in der Nähe der Ader B positioniert.

Der Verbindungspunkt P1 zwischen dem ersten magnetosensitiven Element 1 und dem dritten magnetosensitiven Element 3 ist mit einem Eingang eines Differenzverstärkers D1 verbunden. Der zweite Eingang des Differenzverstärkers D1 ist an den Verbindungspunkt P2 angeschlossen, der sich zwischen dem zweiten magnetosensitiven Element 2 und dem vierten magnetosensitiven Element 4 befindet.

Der Verbindungspunkt P2 ist weiterhin an den ersten Eingang des Differenzverstärkers D2 angeschlossen. Dem zweiten Eingang des Differenzverstärkers D2 werden Signale zugeführt, die vom Verbindungspunkt P3 abgeleitet sind, der zwischen den Widerständen R1 und R2 im ersten Signalzweig liegt.

Am Ausgang des Differenzverstärkers D1 steht ein Fehlersignal F1 zur Verfügung, welches Aufschluß darüber gibt, ob eine der beiden Adern A oder B einen Kurzschluß gegenüber der Leitungsabschirmung oder gegenüber Masse aufweist.

Das am Ausgang des Operationsverstärkers D2 bereitgestellte Signal enthält Informationen darüber, ob eine der Adern A oder B selbst einen Kurzschluß oder eine Unterbrechung hat.

Die in den Figuren 2 und 3 dargestellten magnetosensitiven Elemente 1, 2, 3 und 4 sind vorzugsweise Hall-Elemente, an denen jeweils eine Hall-Spannung abgenommen werden kann. Diese wird vom Magnetfeld hervorgerufen, das durch den Stromfluß in der jeweiligen Ader erzeugt wird.

Die gesamte Auswerteeinheit, die sowohl die magnetosensitiven Elemente als auch die Auswerteschaltung mit den Widerständen und den Differenzverstärkern umfaßt, ist vorzugsweise in Form einer monolithisch integrierten Schaltung realisiert.

Die Überwachung der Datenübertragungsleitungen in Hinblick auf das Auftreten von Impedanzstörstellen wie Kurzschlüssen oder Unterbrechungen erfolgt im Betrieb automatisch und permanent. Auf diese Weise könne ohne großen Personal- und Meßgeräteaufwand Störstellen in Bussystemen erfaßt und lokalisiert werden.

## Patentansprüche

1. Anordnung zur Erfassung von Impedanzstörstellen bei in Form zweier Adern vorliegenden symmetrischen Datenübertragungsleitungen, wobei die Anordnung eine mindestens zwei magnetosensitive Elemente aufweisende Auswerteeinheit (S) aufweist, wobei eines der magnetosensitiven Elemente (1) in räumlicher Nähe der ersten Ader (A) und ein zweites der magnetosensitiven Elemente (2) in räumlicher Nähe der zweiten Ader (B) positioniert ist, und wobei die Auswerteeinheit (S) weiterhin eine mit den magnetosensitiven Elementen verbundene Auswerteschaltung aufweist, die an einem Ausgangsanschluss ein Fehlersignal (F) liefert.

2. Anordnung nach Anspruch 1, wobei die Auswerteschaltung einen ersten Differenzverstärker (D1) aufweist, der an seinem Ausgangsanschluss ein einen Kurzschluss einer Ader gegenüber einem Abschirmelement oder gegenüber Masse anzeigendes Fehlersignal liefert.

3. Anordnung nach Anspruch 1 oder 2, wobei die Auswerteschaltung einen zweiten Differenzverstärker (D2) aufweist, der an seinem Ausgangsanschluss ein einen Kurzschluss zwischen den beiden Adern oder eine Unterbrechung einer der beiden Adern anzeigendes Fehlersignal liefert.

4. Anordnung nach einem der vorhergehenden Ansprüche, wobei die beiden Adern (A, B) parallel zueinander verlaufen und die Auswerteeinheit eine Parallelschaltung mit drei Signalzweigen aufweist, wobei der erste Signalzweig eine Reihenschaltung eines ersten Widerstandes (R1) und eines zweiten Widerstandes (R2), der zweite Signalzweig eine Reihenschaltung des zweiten magnetosensitiven Elementes (2) und eines vierten Widerstandes (R4) und der dritte Signalzweig eine Reihenschaltung des ersten magnetosensitiven Elementes (1) und eines dritten Widerstandes (R3) aufweist.

5. Anordnung nach Anspruch 4, wobei ein erster Eingang des ersten Differenzverstärkers (D1) mit dem Verbindungspunkt (P1) zwischen dem ersten magnetosensitiven Element (1) und dem dritten Widerstand (R3) verbunden ist und ein zweiter Eingang des ersten Differenzverstärkers (D1) mit dem Verbindungspunkt (P2) zwischen dem zweiten magnetosensitiven Element (2) und dem vierten Widerstand (R4) verbunden ist.

6. Anordnung nach Anspruch 4 oder 5, wobei ein erster Eingang des zweiten Differenzverstärkers (D2) mit dem Verbindungspunkt (P2) zwischen dem zweiten magnetosensitiven Element (2) und dem vierten Widerstand (R4) verbunden ist und ein zweiter Eingang des zweiten Differenzverstärkers (D2) mit dem Verbindungspunkt (P3) zwischen dem ersten Widerstand (R1) und dem zweiten Widerstand (R2) verbunden ist.

7. Anordnung nach einem der Ansprüche 1 bis 3, wobei die beiden Adern miteinander verdrillt sind und die Auswerteeinheit eine Parallelschaltung mit drei Signalzweigen aufweist, wobei der erste Signalzweig eine Reihenschaltung eines ersten Widerstandes (R1) und eines zweiten Widerstandes (R2) aufweist, der zweite Signalzweig eine Reihenschaltung des zweiten magnetosensitiven Elementes (2) und eines vierten magnetosensitiven Elementes (4) und der dritte Signalzweig eine Reihenschaltung des ersten magnetosensitiven Elementes (1) und eines dritten magnetosensitiven Elementes (3) aufweist.

8. Anordnung nach Anspruch 7, wobei ein erster Eingang des ersten Differenzverstärkers (D1) mit dem Verbindungspunkt (P1) zwischen dem ersten magnetosensitiven Element (1) und dem dritten magnetosensitiven Element (3) verbunden ist und ein zweiter Eingang des ersten Differenzverstärkers (D1) mit dem Verbindungspunkt (P2) zwischen dem zweiten magnetosensitiven Element (2) und dem vierten magnetosensitiven Element (4) verbunden ist.

9. Anordnung nach Anspruch 7 oder 8, wobei ein erster Eingang des zweiten Differenzverstärkers (D2) mit dem Verbindungspunkt (P2) zwischen dem zweiten magnetosensitiven Element (2) und dem vierten magnetosensitiven Element (4) verbunden ist und ein zweiter Eingang des zweiten Differenzverstärkers (D2) mit dem Verbindungspunkt (P3) zwischen dem ersten Widerstand (R1) und dem zweiten Widerstand (R2) verbunden ist.

10. Anordnung nach einem der vorhergehenden Ansprüche, wobei die Auswerteeinheit in Form einer integrierten Schaltung realisiert ist.

11. Anordnung nach einem der vorhergehenden Ansprüche, wobei die Auswerteeinheit zur permanenten Überwachung der Datenübertragungsleitungen vorgesehen ist.

12. Anordnung nach einem der vorhergehenden Ansprüche, wobei sie Bestandteil eines Datenbussystems ist.

13. Anordnung nach einem der vorhergehenden Ansprüche, wobei die magnetosensitiven Elemente Hall-Elemente sind.

## Claims

1. Device for detecting impedance disturbance points in symmetrical data transmission lines in the form of two conductor strands, the device having an evaluation unit (S) having at least two magnetosensitive elements, one of the magnetosensitive elements (1) being positioned in the proximity of the first conductor strand (A) and a second one of the magnetosensitive elements (2) being positioned in the proximity of the second conductor strand (B), and the evaluation unit (S) furthermore having an evaluation circuit connected to the magnetosensitive elements which supplies a fault signal (F) at an output terminal.

2. Device according to Claim 1, the evaluation circuit having a first differential amplifier (D1), which supplies at its output terminal a fault signal indicating a short circuit of a conductor strand with respect to a shielding element or with respect to earth.

3. Device according to Claim 1 or 2, the evaluation circuit having a second differential amplifier (D2), which supplies at its output terminal a fault signal indicating a short circuit between the two conductor strands or an interruption of one of the two conductor strands.

4. Device according to one of the preceding claims, the two conductor strands (A, B) running parallel to each other and the evaluation unit having a parallel connection with three signal branches, the first signal branch having a series connection of a first resistor (R1) and a second resistor (R2), the second signal branch having a series connection of the second magnetosensitive element (2) and a fourth resistor (R4) and the third signal branch having a series connection of the first magnetosensitive element (1) and a third resistor (R3).

5. Device according to Claim 4, a first input of the first differential amplifier (D1) being connected to the connecting point (P1) between the first magnetosensitive element (1) and the third resistor (R3) and a second input of the first differential amplifier (D1) being connected to the connecting point (P2) between the second magnetosensitive element (2) and the fourth resistor (R4).

6. Device according to Claim 4 or 5, a first input of the second differential amplifier (D2) being connected to the connecting point (P2) between the second magnetosensitive element (2) and the fourth resistor (R4) and a second input of the second differential amplifier (D2) being connected to the connecting point (P3) between the first resistor (R1) and the second resistor (R2).

7. Device according to one of Claims 1 to 3, the two conductor strands being twisted with each other and the evaluation unit having a parallel connection with three signal branches, the first signal branch having a series connection of a first resistor (R1) and a second resistor (R2), the second signal branch having a series connection of the second magnetosensitive element (2) and a fourth magnetosensitive element (4) and the third signal branch having a series connection of the first magnetosensitive element (1) and a third magnetosensitive element (3).

8. Device according to Claim 7, a first input of the first differential amplifier (D1) being connected to the connecting point (P1) between the first magnetosensitive element (1) and the third magnetosensitive element (3) and a second input of the first differential amplifier (D1) being connected to the connecting point (P2) between the second magnetosensitive element (2) and the fourth magnetosensitive element (4).

9. Device according to Claim 7 or 8, a first input of the second differential amplifier (D2) being connected to the connecting point (P2) between the second magnetosensitive element (2) and the fourth magnetosensitive element (4) and a second input of the second differential amplifier (D2) being connected to the connecting point (P3) between the first resistor (R1) and the second resistor (R2).

10. Device according to one of the preceding claims, the evaluation unit being realized in the form of an integrated circuit.

11. Device according to one of the preceding claims, the evaluation unit being intended for the permanent monitoring of the data transmission lines.

12. Device according to one of the preceding claims, which is a component part of a data bus system.

13. Device according to one of the preceding claims, the magnetosensitive elements being Hall-effect elements.

## Revendications

1. Dispositif de détection de points de perturbation par impédance dans des lignes de transmission de données symétriques se présentant sous la forme de deux fils, le dispositif comprenant au moins une unité (S) d'exploitation ayant deux éléments magnétosensibles, l'un des éléments (1) magnétosensibles étant placé à proximité du premier fil (A) et un deuxième des éléments (2) magnétosensibles étant placé à proximité du deuxième fil (B), et l'unité (S) d'exploitation comportant en outre un circuit d'exploitation relié aux éléments magnétosensibles et fournissant un signal (F) de défaut sur une borne de sortie.

2. Dispositif suivant la revendication 1, dans lequel le circuit d'exploitation a un premier amplificateur (D1) différentiel qui fournit sur sa borne de sortie un signal de défaut indiquant un court-circuit d'un fil par rapport à un élément de blindage ou par rapport à la masse.

3. Dispositif suivant la revendication 1 ou 2, dans lequel le circuit d'exploitation a un deuxième amplificateur (D2) différentiel qui fournit sur sa borne de sortie un signal de défaut indiquant un court-circuit entre les deux fils ou une rupture de l'un des deux fils.

4. Dispositif suivant l'une des revendications précédentes, dans lequel les deux fils (A, B) s'étendent parallèlement l'un à l'autre et l'unité d'exploitation a un circuit parallèle ayant trois branches de signal, la première branche de signal comportant un circuit série constitué d'une première résistance (R1) et d'une deuxième résistance (R2), la deuxième branche de signal un circuit série constitué du deuxième élément magnétosensible et d'une quatrième résistance (R4) et la troisième branche de signal un circuit série constitué du premier élément (1) magnétosensible et d'une troisième résistance (R3).

5. Dispositif suivant la revendication 4, dans lequel une première entrée du premier amplificateur (D1) différentiel est reliée au point (P1) de liaison compris entre le premier élément (1) magnétosensible et la troisième résistance (R3), et une deuxième entrée du premier amplificateur (D1) différentiel est reliée au point (P2) de liaison entre le deuxième élément (2) magnétosensible et la quatrième résistance (R4).

6. Dispositif suivant la revendication 4 ou 5, dans lequel une première entrée du deuxième amplificateur (D2) différentiel est reliée au point (P2) de liaison compris entre le deuxième élément (2) magnétosensible et la quatrième résistance (R4), et une deuxième entrée du deuxième amplificateur (D2) différentiel est reliée au point (P3) de liaison compris entre la première résistance (R1) et la deuxième résistance (R2).

7. Dispositif suivant l'une des revendications 1 à 3, dans lequel les deux fils sont torsadés ensemble et l'unité d'exploitation comporte un circuit parallèle ayant trois tranches de signal, la première branche de signal comportant un circuit série constitué d'une première résistance (R1) et d'une deuxième résistance (R2), la deuxième branche de signal un circuit série constitué du deuxième élément (2) magnétosensible et d'un quatrième élément (4) magnétosensible et la troisième branche de signal un circuit série constitué du premier élément (1) magnétosensible et du troisième élément (3) magnétosensible.

8. Dispositif suivant la revendication 7, dans lequel une première entrée du premier amplificateur (D1) différentiel est reliée au point (P1) de liaison compris entre le premier élément (1) magnétosensible et le troisième élément (3) magnétosensible, et une deuxième entrée du premier amplificateur (D1) différentiel est reliée au point (P2) de liaison compris entre le deuxième élément (2) magnétosensible et le quatrième élément (4) magnétosensible.

9. Dispositif suivant la revendication 7 ou 8, dans lequel la première entrée du deuxième amplificateur (D2) différentiel est reliée au point (P2) de liaison compris entre le deuxième élément (2) magnétosensible et le quatrième élément (4) magnétosensible, et une deuxième entrée du deuxième amplificateur (D2) différentiel est reliée au point (P3) de liaison compris entre la première résistance (R1) et la deuxième résistance (R2).

10. Dispositif suivant l'une des revendications précédentes, dans lequel l'unité d'exploitation est réalisée sous la forme d'un circuit intégré.

11. Dispositif suivant l'une des revendications précédentes, dans lequel l'unité d'exploitation est prévue pour le contrôle permanent des lignes de transmission de données.

12. Dispositif suivant l'une des revendications précédentes, qui fait partie d'un système de bus de données.

13. Dispositif suivant l'une des revendications précédentes, dans lequel les éléments magnétosensibles sont des éléments de Hall.
